Europäisches Patentamt

European Patent Office

Office européen des brevets

(19)

(11) EP 0 839 324 B1

(12) **FASCICULE DE BREVET EUROPEEN**

(45) Date de publication et mention
de la délivrance du brevet:
**31.03.1999 Bulletin 1999/13**

(21) Numéro de dépôt: **96924969.7**

(22) Date de dépôt: **16.07.1996**

(51) Int Cl.⁶: **G01R 29/24**

(86) Numéro de dépôt international:
**PCT/FR96/01101**

(87) Numéro de publication internationale:
**WO 97/04322 (06.02.1997 Gazette 1997/07)**

(54) **SYSTEME ET PROCEDE DE MESURE DU CONTENU ELECTRONIQUE TOTAL DE LA IONOSPHERE**

**SYSTEM UND VERFAHREN ZUM MESSEN DES TOTALEN ELEKTRONENGEHALTS DER IONOSHPÄRE**

**SYSTEM AND METHOD FOR MEASURING THE TOTAL ELECTRON CONTENT OF THE IONOSPHERE**

(84) Etats contractants désignés:
**DE ES FR GB IT SE**

(30) Priorité: **17.07.1995 FR 9508612**

(43) Date de publication de la demande:
**06.05.1998 Bulletin 1998/19**

(73) Titulaire: **CENTRE NATIONAL D'ETUDES SPATIALES**
**F-75039 Paris Cedex 01 (FR)**

(72) Inventeur: **ISSLER, Jean-Luc**
**F-31400 Toulouse (FR)**

(74) Mandataire: **Des Termes, Monique et al**
**Société Brevatome**
**25, rue de Ponthieu**
**75008 Paris (FR)**

(56) Documents cités:
EP-A- 0 430 587          US-A- 4 463 357
US-A- 5 323 322

**Description**

Domaine technique

La présente invention concerne un système et un procédé de mesure du contenu électronique total de la ionosphère.

Etat de la technique antérieur

Comme décrit dans la référence [1], la ionosphère est une série de couches ionisées excitées par les rayonnements solaires. Elle se caractérise par sa densité électronique N (nombre d'électrons par mètre cube) dépendant de l'altitude h et son contenu électronique total CET (nombre total d'électrons dans une colonne verticale de 1 m$^2$ de section), qui peut être défini par les relations suivantes :

$$10^{16} \ e^{-}/m^2 < CET < \text{quelques } 10^{18} \ e^{-}/m^2$$

$$CET = \int_{0}^{\infty} N(h) \, dh$$

La ionosphère est un milieu dispersif pour les ondes électromagnétiques. Sa fonction de transfert $H_{iono}(f)$ est telle que :

$$H_{(iono)}(f) = A_{(iono)}(f).e^{-j.\Phi_{iono}(f)}$$

$A_{iono}(f)$ est le coefficient de transmission de la ionosphère. Ce coefficient dépend de la fréquence. Les transmissions ne sont plus très efficaces pour des fréquences inférieures à 100 MHz, en raison de réflexions ou rebonds des ondes électromagnétiques sur les couches ionisées.

Le déphase $\Phi_{iono}(f)$ de $H_{iono}(f)$, en première approximation, pour un trajet terre-espace est tel que :

$$\Phi_{iono}(f) = \frac{-2.\pi.40,3 \ CET}{c.sin(Ei)} \cdot \frac{1}{f}$$

Ei est l'angle d'élévation de l'onde électromagnétique, à l'altitude du maximum de N (point subionosphérique). La vitesse de la lumière est notée c.

Le temps de propagation de groupe $\tau g_{iono}(f)$ de la ionosphère est donc :

$$\tau g_{iono}(f) = \frac{1}{2\pi} \cdot \frac{d\Phi_{iono}}{df} \ \# \ \frac{40,3. \ CET}{c.sin \ (Ei)} \cdot \frac{1}{f^2}$$

L'erreur de $\Delta D_{iono}$ de mesure de pseudodistance se déduit de $\tau g_{iono}(f)$ :

$$\Delta D_{iono} = C \cdot \tau g_{iono}(f)$$

Le temps de propagation de phase $\tau \varphi_{iono}(f)$ de la ionosphère est donc :

$$\tau \varphi_{iono}(f) = \frac{1}{2\pi} \cdot \frac{\Phi_{iono}}{f} \ \# \ \frac{-40,3. \ CET}{c.sin \ (Ei)} \cdot \frac{1}{f^2}$$

L'erreur $\Delta V_{iono}$ de mesure de pseudovitesse radiale se déduit du temps de propagation de phase de la ionosphère, noté $\tau \varphi_{iono}(f)$ :

$$\Delta V_{iono} = \frac{d\tau\varphi_{iono}(f)}{dt} \# \frac{d\tau g_{iono}(f)}{dt} \# \frac{-40,3. \; CET \; . \; dEi/dt}{c. \; tan(Ei).sin(Ei).f^2} -$$

$$\frac{40,3.dCET/dt}{c.sin(Ei).f^2}$$

Les systèmes de radio navigation localisation prétendant accéder à une bonne précision de localisation sont jusqu'à présent bifréquences. Supposons que les fréquences utilisées soient f1 et f2, les mesures de distances correspondantes sont notées D1 et D2.

On obtient un système de deux équations à deux inconnues :

$$D1 = d + \Delta D_{iono}(f1)$$

$$D2 = d + \Delta D_{iono}(f2)$$

d'où :

$$CET \; = \; \frac{(D1 - D2) \; . \; \sin\left(Ei\right) \; . \; f1^2 \; . \; f2^2}{40,3 \; . \; \left(f1^2 \; - \; f2^2\right)}$$

$$d = \frac{f2^2 \; . \; D1\text{-}f1^2 \; . \; D2}{f2^2 \; \text{-} \; f1^2}$$

Des équations similaires sont obtenues dans le cas de mesures de vitesse bifréquence.

Parfois, certains systèmes de radio navigation localisation sont contraints par l'utilisation d'une seule fréquence, alors qu'une certaine précision de localisation est recherchée. Le système doit donc disposer d'une ionographie, afin de pouvoir corriger les mesures ; ce qu'il ne peut pas faire directement en général. Cette ionographie peut être effectuée à l'aide de toutes les mesures réalisées par le système lui-même.

Cette opération est facilitée si le système dispose de références aux coordonnées parfaitement connues (citons le cas des balises d'orbitographie du système DORIS, qui pourtant est un système bifréquence). En ce cas, les fonctions de ionographie et d'orbitographie sont souvent couplées. Ainsi le système GPS, bien que bifréquence, réalise une ionographie qui est ensuite diffusée dans le message de référence des satellites, sous la forme de coefficients d'un modèle de ionosphère ajusté par des mesures de CET. Cette ionographie est alors utilisée par les récepteurs GPS monofréquence placés au voisinage immédiat de la surface terrestre. Cet exemple montre qu'un système de radiolocalisation monofréquence peut également s'appuyer sur une tonographie réalisée par un système mondial bifréquence extérieur, tel que DORIS, FRARE, GPS ou GLONASS.

cet exemple est décrit dans le document « STANAG 4294 ; Standardization Agreement (STANAG) Subject NAVSTAR Global Positioning System (GPS) System Characteristics - Preliminary Draft (Draft issue - Date : 1st August 1990) » dans le cas du système GPS.

Le modèle de ionosphère diffusé par la constellation GPS a été optimisé pour des trajets terre-espace. Il n'est donc pas toujours adapté au cas d'un récepteur GPS monofréquence placé en orbite basse. L'utilisation du filtrage de Kalman des mesures brutes permet de réaliser simultanément une orbitographie autonome ainsi qu'une ionographie autonome. De tels filtres de Kalman pour les récepteurs GPS C/A spatiaux sont actuellement à l'étude.

Le vecteur d'état de ces filtres contient à la fois les paramètres d'orbite, les paramètres d'horloge ainsi que des paramètres de la ionosphère.

La référence [2] montre comment des mesures à une seule fréquence peuvent être utilisées pour réaliser une estimation en temps réel des retards de propagation dus à la ionosphère.

La référence [3] décrit une estimation du retard ionosphérique absolu uniquement grâce à des mesures GPS à une fréquence. Le délai ionosphérique est obtenu en mesurant la divergence relative entre le code GPS et la porteuse GPS.

La présente invention a pour objet de pallier les inconvénients des dispositifs de l'art antérieur, et donc de mesurer le retard ionosphérique en utilisant les émetteurs VHF en spectre étalé qui existent dans certains satellites, et notamment les petits satellites, permettant une liaison avec le sol.

Exposé de l'invention

La présente invention concerne un système de mesure du contenu électrique total de la ionosphère comprenant :

-    à bord d'un satellite, un émetteur d'un signal cohérent en spectre étalé transmis en VHF ;
-    au sol, un dispositif de réception et de traitement du signal VHF reçu permettant de mesurer le contenu électronique total de la ionosphère.

Le segment bord peut être couplé avec une fonction d'initialisation autonome des liaisons spatiales directives ou/et une fonction de transmission de secours, prévue pour certains satellites.

La présente invention concerne également un procédé de mesure du contenu électronique total de la ionosphère, à l'aide d'un signal en spectre étalé transmis à travers la ionosphère dans la bande VHF, ce procédé étant caractérisé en ce qu'on émet à partir d'un satellite un signal constitué d'un code pseudo-aléatoire dans la bande VHF.

On peut également émettre à partir d'une station sol un signal semblable au précédent, répété par un satellite dans la bande VHF.

Dans les deux cas, on reçoit le signal transmis par le satellite dans la station sol, les mesures disponibles dans la station (vitesse de groupe, vitesse de phase) étant utilisées pour déterminer le contenu électronique total de la ionosphère.

Les mesures disponibles dans la station (distance, Doppler) sont corrigées des effets de la ionosphère à l'aide de la connaissance du contenu électronique total. Ces mesures corrigées sont utilisées pour déterminer l'orbite dudit satellite.

Brève description des dessins

-    La figure 1 illustre le système de l'invention ;
-    la figure 2 illustre un exemple de segment bord classique ;
-    la figure 3 illustre une courbe d'orbitographie sur laquelle sont représentés les cercles de visibilité de stations d'orbitographie et les cercles de visibilité de zones de service.

Exposé détaillé de modes de réalisation

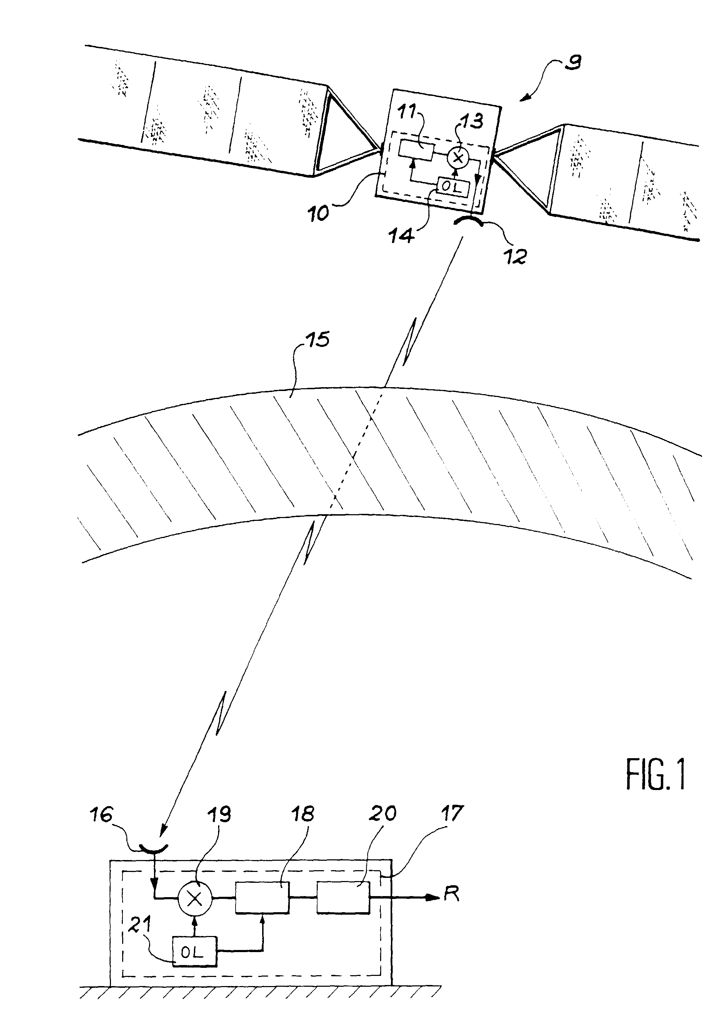

Comme représenté sur la figure 1 le segment bord 10 à l'intérieur d'une satellite 9 comprend un générateur 11 de signaux en spectre étalé en fréquence intermédiaire (par exemple, un générateur de code C/A GPS ou GLONASS en bande L1) relié à une antenne 12 au travers d'un mélangeur 13, un oscillateur local OL 14 étant relié au générateur 11 et au mélangeur 13 dans le but d'assurer la cohérence entre le code et la porteuse du signal transmis. L'antenne 12 émet un signal en VHF qui, après traversée de la ionosphère 15, est reçu par l'antenne 16 d'une station sol 17. Cette station sol 17 comprend un récepteur de signaux en spectre étalé (par exemple GPS-C/A ou GLONASS-C/A 18, de bande L1) connecté à l'accès de l'antenne 16 au travers d'un amplificateur et d'un mélangeur 19, et en sortie à un ordinateur 20 lui-même relié à un réseau R de stations sols. Un oscillateur local OL 21 est relié au récepteur 18 et au mélangeur 19. Le segment bord 10 et la station sol 17 peuvent avoir des fréquences OL ayant la même valeur.

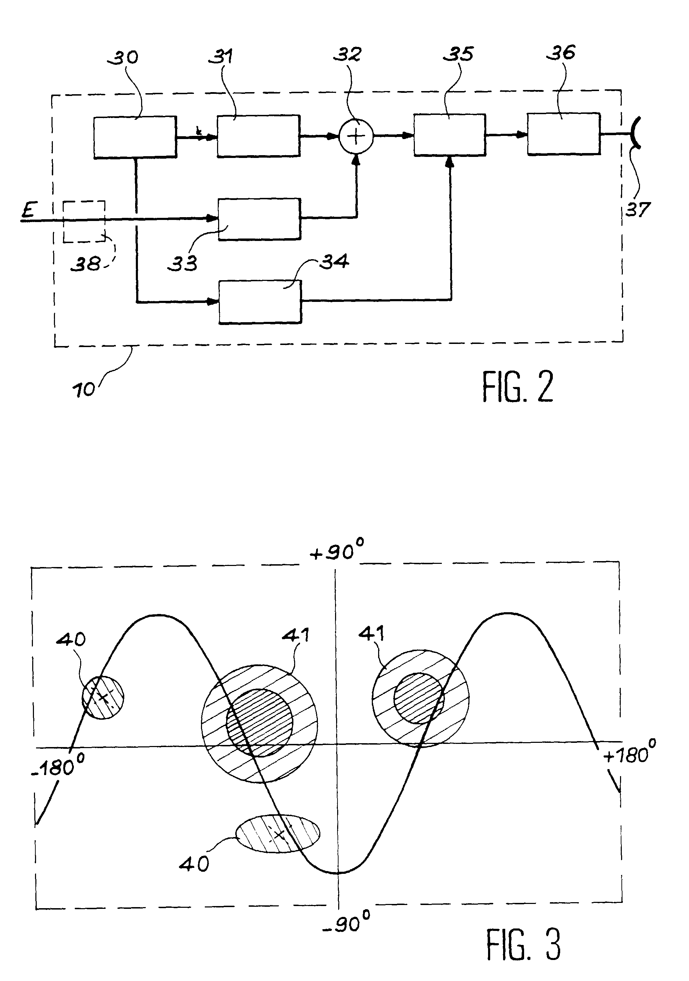

La figure 2 illustre un exemple classique de réalisation d'un segment bord 10.

L'oscillateur 30 est relié à un générateur de code pseudo-aléatoire 31, lui-même relié à un sommateur 32, qui reçoit sur une autre entrée un signal provenant d'un générateur de message binaire 33 dont le signal d'entrée est référencé E.

L'oscillateur 30 est également relié à un générateur de signal VHF 34. Un modulateur amplificateur 35 (par exemple modulateur MDP2 : modulateur de phase à deux états) reçoit les sorties du sommateur 32 et du générateur 34.

Un amplificateur 36 reçoit le signal de sortie de ce modulateur 35 et est relié à une antenne 37.

Eventuellement un formateur de données 38 peut être positionné sur l'entrée du générateur 33.

Un système de satellite de l'art connu permet de desservir plusieurs zones de service industrialisées contraignantes en terme d'environnement de brouillage radioélectrique, comme représenté sur la figure 3, les cercle de visibilité des stations d'orbitographie étant référencés 40 et les cercles de visibilité des zones de service étant référencés 41.

La charge utile de transmission en VHF n'est pas sensée être utilisée en tant que telle en dehors du survol de ces zones de service.

Un signal de localisation en spectre étalé bénéficiant du maximum de puissance disponible à bord est émis vers le sol lorsque le satellite n'est pas en visibilité d'une zone de service. Ce signal n'est donc pas perturbé par les signaux traités lors des survols des zones de service par la charge utile de transmission. Une ou plusieurs stations réduites de réception situées en dehors de ces zones de visibilité peuvent enregistrer les mesures de pseudovitesse et de pseudodistance réalisées à l'aide du signal reçu, pendant toute la durée du passage de chaque satellite. Ces stations retransmettent leurs mesures à un centre d'orbitographie, par l'intermédiaire d'une ligne de communication (filaire, spatiale ou mixte). Les sites des stations d'orbitographie sont choisis pour être peu brouillés. De plus, le signal de localisation utilise une liaison espace-terre, peu affectée par les brouilleurs.

Le signal émis en dehors des périodes de visibilité des zones de service est choisi pour permettre la réalisation d'une orbitographie suffisamment précise pour représenter un poste minime dans le bilan d'erreur de localisation des terminaux utilisateurs situés dans les zones de service. Pour cela, on détermine précisément le retard et le Doppler ionosphérique altérant le signal reçu par les stations d'écoute déportées (ionographie associée aux stations d'orbitographie). Ce retard permet de corriger les mesures utilisées pour l'orbitographie du satellite.

Lorsque cette orbitographie suffisamment précise est connue, il est possible de réaliser la ionographie associée aux zones de service à l'aide de terminaux de référence situés dans lesdites zones.

En effet, si la position de ces terminaux de référence et des satellites est bien connue à tout instant, les mesures de type station-satellite-terminal-satellite-station permettent de déterminer la ionographie associée aux zones de service, tout comme les mesures de type station-satellite-station.

La charge utile génère un pilote en spectre étalé en VHF. Ce signal est généré de façon cohérente à partir de l'oscillateur local (OL) bord. Il bénéficie de la chaîne d'amplification de la voie émission VHF, grâce à un commutateur.

Afin d'écrire l'équation de mesure du contenu électronique total (CET) par le récepteur de la station d'orbitographie, on définit les notations suivantes :

$fo$ = fréquence théorique de la porteuse du signal en spectre étalé (Hz)
$Ei$ = angle d'élévation ionosphérique (rad)
$c$ = vitesse de la lumière (m/s)
$Cr$ = glissement code/porteuse (m/s)
$Vgr$ = vitesse de groupe ou vitesse du code (m/s)
$V\varphi r$ = vitesse de phase ou vitesse de la porteuse (m/s)
$ti$ = instant de mesure(s)
$mg$ = mesure du temps de propagation de groupe, i.e. pseudodistance, dans le cas présent (m)
$\varphi$ = mesure de la phase de la porteuse du signal reçu (rad)
$\sigma_f$ = écart type de la mesure de fréquence reçue (Hz)
$\sigma_{mg}$ = écart type de la mesure du temps de propagation de groupe (m)

On obtient :

$$CET \; \# \; \frac{Cr \cdot \tan(Ei) \cdot \sin(Ei) \cdot fo^2}{80{,}6 \cdot \left(\dfrac{dEi}{dt}\right)}$$

$$Cr = Vgr - V\varphi r$$

$$Vgr = \frac{mg(t2) - mg(t1)}{t2 - t1}$$

$$V\varphi r = \frac{1}{2\pi} \times \frac{c}{fo} \times \frac{\varphi(t2) - \varphi(t1)}{t2 - t1}$$

L'originalité du système de l'invention consiste à utiliser la bande de fréquence VHF bien plus adaptée que d'autres bandes (comme la bande L) pour réaliser les mesures de CET à l'aide d'un seule fréquence. Ces mesures

**EP 0 839 324 B1**

peuvent être filtrées pour affiner l'estimation du CET.

L'ensemble du segment bord, par exemple d'un petit satellite, peut être un émetteur VHF cohérent en spectre étalé standard. L'antenne d'émission et l'oscillateur peuvent être standard, eux aussi. L'oscillateur doit toutefois être suffisamment stable, de façon à ce que sa contribution à la mesure de Vφr soit négligeable.

Le segment bord décrit précédemment peut être couplé avec une autre fonction de ces satellites, les petits satellites en particulier : l'initialisation autonome des liaisons spatiales directives.

Les petits satellites mettent en général en jeu deux types de liaisons spatiales :

- non directives (à relativement faible débit, en VHF par exemple) ;
- directives (à relativement haut débit, en bande S par exemple).

L'invention peut donc utiliser les besoins déjà existants de satellites, par exemple de petits satellites, qui utilisent un émetteur en spectre étalé en VHF pour transmettre des données vers le sol et permettre de faire des mesures de distance et/ou de vitesse dudit satellite en effectuant le traitement des signaux reçus au sol, pour effectuer une mesure du retard ionosphérique.

On peut envisager un fonctionnement bidirectionnel, c'est-à-dire une liaison montante suivie d'une liaison descendante, en utilisant un répéteur transparent ou transpondeur à l'intérieur du satellite. Dans ce cas, la station sol utilisatrice est une station d'émission/réception. Cette station contient à la fois le dispositif 10 de génération et d'émission des signaux, ainsi que le segment sol de réception 17 décrit précédemment. Dans ce cas, les signaux générés par les oscillateurs locaux 14 et 21 sont générés de façon cohérente, à partir de la même référence de fréquence. Dans le cas d'un tel fonctionnement bidirectionnel, on peut également utiliser deux bandes de fréquence (par exemple bande UHF pour la liaison montante et bande VHF pour la liaison descendante).

REFERENCES

[1] "Techniques et technologies des véhicules spatiaux" (CNES, Cépaduès-Editions, tome 1, module 6, pages 628 à 633)

[2] "Single Frequency Ionosphère Determination Using GPS" de M.L. Trethewey, I. Catchpole et A. Hansla (IONGPS-93 Proc., septembre 1993, pages 1373 à 1381)

[3] "Estimation of Absolute Ionospheric Delay Exclusively Through Single- Frequency GPS Measurements" de C. E. Cohen, B. Peervan et B.W. Parkinson (ION GPS-92 Proc., septembre 1992, pages 325 à 330)

**Revendications**

1. Utilisation pour la mesure du contenu électronique total de la ionosphère :

   - d'un émetteur (11) d'un signal cohérent en spectre étalé transmis en VHF, situé à bord d'un satellite (9) ;
   - et d'un dispositif de réception (18) et de traitement du signal VHF reçu, situé au sol, permettant de mesurer le contenu électrique total(CET) de la ionosphère à l'aide d'une seule fréquence.

2. Utilisation selon la revendication 1, caractérisée en ce que le segment bord est couplé avec une fonction d'initialisation autonome des liaisons spatiales directives, ou/et une fonction de transmission de secours.

3. Procédé de mesure du contenu électronique total de la ionosphère, caractérisé en ce qu'on réalise des mesures de vitesse de croupe et de phase effectuées sur un signal en spectre étalé cohérent transmis à travers la ionosphère dans la bande VHF, et en ce que qu'on émet à partir d'un satellite un signal constitué d'un code pseudo-aléatoire modulant de manière cohérente une porteuse située dans la bande VHF.

4. Procédé selon la revendication 3, caractérisé en ce qu'on émet à partir d'une station sol un signal semblable au précédent, répété par un satellite dans la bande VHF.

5. Procédé selon la revendication 3, caractérisé en ce qu'on reçoit le signal transmis par le satellite dans la station sol, les mesures disponibles dans la station (vitesse de groupe, vitesse de phase) étant utilisées pour déterminer le contenu électronique total de la ionosphère.

6. Procédé selon la revendication 3, caractérisé en ce que les mesures disponibles dans la station (distance, Doppler) sont corrigées des effets de la ionosphère, à l'aide de la connaissance du contenu électronique total, ces mesures corrigées étant utilisées pour déterminer l'orbite dudit satellite.

**Patentansprüche**

1. System zum Messen des totalen Elektronengehalts der Ionosphäre, umfassend:

   - einen Sender (11) eines kohärenten VHF-Signals mit breitem Spektrum, an Bord eines Satelliten (9) befindlich, und
   - eine Empfangs- und Verarbeitungsvorrichtung (18) des empfangenen VHF-Signals, am Boden befindlich, die ermöglicht, den totalen Elektronengehalt (CET) der Ionosphäre mit Hilfe einer einzigen Frequenz zu messen

2. System nach Anspruch 1, dadurch gekennzeichnet, das das Bord-Segment gekoppelt ist mit einer autonomen Initialisierungsfunktion der räumlichen Richtverbindungen und/oder einer Sendungs- bzw. Übertragungs-Hilfsfunktion.

3. Verfahren zum Messen des totalen Elektronengehalts der Ionosphäre, dadurch gekennzeichnet, daß man Gruppen- und Phasengeschwindigkeitsmessungen an einem im VHF-Band durch die Ionosphäre gesendeten kohärenten Signal mit breitem Spektrum durchführt, und dadurch, daß man von einem Satelliten aus ein Signal sendet, gebildet durch einen pseudo-zufälligen Code, der in kohärenter Weise einen Träger moduliert, der sich im VHF-Band befindet.

4. Verfahren nach Anspruch 3, dadurch gekennzeichnet, daß man von einer Bodenstation aus ein dem vorhergehenden ähnliches bzw. gleichendes Signal sendet, das durch einen Satelliten im VHF-Band wiederholt wird.

5. Verfahren nach Anspruch 3, dadurch gekennzeichnet, daß man das durch den Satelliten übertragene bzw. gesendete Signal in der Bodenstation empfängt, wobei die in der Station verfügbaren Messungen (Gruppengeschwindigkeit, Phasengeschwindigkeit) benutzt werden, um den totalen Elektronengehalt der Ionosphäre zu bestimmen.

6. Verfahren nach Anspruch 3, dadurch gekennzeichnet, daß die in der Station verfügbaren Messungen (Distanz, Doppler) mit Hilfe der Kenntnis des totalen Elektronengehalts korrigiert werden von den Effekten der Ionosphäre, wobei diese korrigierten Messungen benutzt werden, um den Orbit des genannten Satelliten zu bestimmen.

**Claims**

1. Use for measuring the total electronic content of the ionosphere, comprising:

   - aboard a satellite (9), of a transmitter (11) of a coherent spread spectrum signal transmitted in VHF,
   - on the ground, of a device (18) for receiving and processing the VHF signal received enabling the total electronic content of the ionosphere (TEC) to be measured using a single frequency.

2. Use according to claim 1, characterized by the fact that the on-board section is coupled to an independent directive spatial link initializing function and/or a backup transmission function.

3. Process for measuring the total electronic content of the ionosphere, characterized in that group and phase velocity measurements are performed on a spread spectrum signal transmitted through the ionosphere in the VHF band, and in that a satellite transmits a signal composed of a pseudorandom code coherently modulating a carrier in the VHF band.

4. Process according to claim 3, characterized in that a ground station transmits a signal similar to the above, repeated by a satellite in the VHF band.

5. Process according to claim 3, characterized in that the signal transmitted by the satellite is received by a ground station, the measurements available at the station (group velocity, phase velocity) are used to determine the total electronic content of the ionosphere.

6. Process according to claim 3, characterized in that the measurements available at the station (distance, Doppler) are corrected for the effects of the ionosphere using knowledge of the total electronic content, said corrected measurements being used to determine the orbit of said satellite.

FIG.1

FIG. 2

FIG. 3